Europäisches Patentamt

(19) European Patent Office

Office européen des brevets

(11) Publication number: **0 189 571**
A1

(12) **EUROPEAN PATENT APPLICATION**

(21) Application number: 85115851.9

(22) Date of filing: 12.12.85

(51) Int. Cl.⁴: **H 03 K 19/094**
**H 03 K 5/02**

(30) Priority: 24.12.84 US 685515

(43) Date of publication of application:
06.08.86 Bulletin 86/32

(84) Designated Contracting States:
DE FR GB IT

(71) Applicant: GENERAL ELECTRIC COMPANY
1 River Road
Schenectady New York 12305(US)

(72) Inventor: Rogers, Marbrey Lee, Jr.
200 Earl Road
Vestal New York 13850(US)

(74) Representative: Catherine, Alain et al,
General Electric - Deutschland Munich Patent Operations
Frauenstrasse 32
D-8000 München 5(DE)

(54) CMOS with "shoot-through" current control.

�ግ Undesired current flow in a CMOS driver circuit (31) is minimized or eliminated during the portion of the switching interval when both transistors (42, 43) are conducting. The p-MOS and the n-MOS transistors (33, 34) in the CMOS inverter switching circuit (30) coupled to the gates of the driver CMOS (31) are interconnected through CMOS transistors (36, 37) which are continuously biased on. During switching, a voltage is developed across these CMOS transistors (36, 37) which delays turn-on of the non-conducting driver CMOS transistor (42 or 43) until the current in the complementary driver transistor (43 or 42) is reduced to a low value or to zero.

This invention relates to CMOS transistor circuitry in which parasitic current flow during switching of the transistor is minimized or eliminated.

FIG.2

In complementary metal oxide semiconductors (CMOS), n-channel and p-channel transistors are positioned adjacent to each other on a semiconductive substrate. Insulated gate electrodes are associated with the individual channels of the CMOS transistors. The p- and n-channel transistors are alternately switched into conduction depending on the polarity of the voltage at the gate electrodes. Thus, with a negative gate voltage, the p-channel MOS conducts to produce a positive output and, conversely, with a positive gate voltage the n-channel MOS conducts and the output voltage is negative. CMOS circuits are, however, subject to a phenomenon known as "shoot-through" current; a phenomenon which occurs when the complementary n- and p-channel transistors are switching conducting states. As the switching gate voltage changes from positive to negative, or vice versa, there is a value of the gate voltage at which the conducting transistor has not yet switched off and the previously nonconducting transistor has already begun to conduct. As a result, a portion of the current, instead of flowing through one of the transistors to the load, flows from the positive supply lead through both transistors into the negative supply lead. This portion of the current which "shoots-through" the two transistors is a parasitic current which performs no useful purpose, since it bypasses the load. Not only does it not perform any useful purpose, but it has undesirable consequences in that it requires additional power supply capacity and generates additional heat.

The problem of such parasitic current is present in all CMOS devices but can be particularly troublesome in the case of high current, high speed output driver circuits such as those used in VLSI chips and multiple gate arrays. The problem is twofold. In such circuits the output driver circuits themselves are large and can draw large current so that the parasitic current is itself fairly substantial; and secondly, in gate arrays where many, many such driver circuits are utilized in parallel (16 such drivers or more), the total parasitic current is increased even further.

Applicant has found that the parasitic "shoot-through" current during the switching mode of CMOS circuitry may be substantially reduced or eliminated altogether by incorporating a network, in the form of conductively biased CMOS transistors, in the CMOS switching circuit which controls the gate signals for the CMOS output drivers. The voltage drop across these transistors during the switching mode is applied to the gate circuit of the nonconducting transistor and delays its turn-on until the previously conducting transistor is either completely turned off or turned off to a very low level of conductivity. Consequently, as the second transistor begins to turn on, the current flow in both transistors is low and parasitic "shoot-through" current is either eliminated entirely or reduced substantially.

It is therefore a principal objective of this invention to provide CMOS circuitry in which parasitic "shoot-through" current is minimized or eliminated.

Another objective of the invention is to provide a means in which "turn-on" of CMOS transistor during the switching mode is delayed while "turn-off" of the other transistor continues to minimize parasitic "shoot-through" current.

Other advantages and objectives of the invention will become apparent as the description thereof proceeds.

The various objectives and advantages of the invention are realized in a high current, high speed CMOS driver circuit by controlling the input gate signal to the high current CMOS drivers from a CMOS switching circuit which includes a "turn-on" delay circuit, in the form of a pair of back-to-back conductively biased CMOS transistors.

When a switching signal is applied to the gates of the CMOS switching circuit, the previously conducting transistor begins to turn off and the output voltage at its drain electrode changes in a direction which begins to turn off the conducting transistor in the CMOS driver circuit. The conductively biased CMOS transistor coupled between the n- and p-channel transistors of the switching circuit draw current and develop a voltage of such a polarity so as to delay turn-on of the non-conducting driver transistor. Thus, conduction of the previously nonconducting transistor begins only after the current level in the formerly conducting transistor is very low, thereby minimizing the amount of "shoot-through" current.

Other features believed characteristic of this invention are set forth with particularity in the appended claims. The invention itself, however, together with other objectives and advantages thereof will be best understood by reference of the following description taken in conjunction with the accompanying drawings in which:

Figure 1 is a schematic illustration of a prior art, high current, high speed CMOS output driver circuitry.

Figure 2 is a schematic of the high current, high speed CMOS driver circuit of the instant invention.

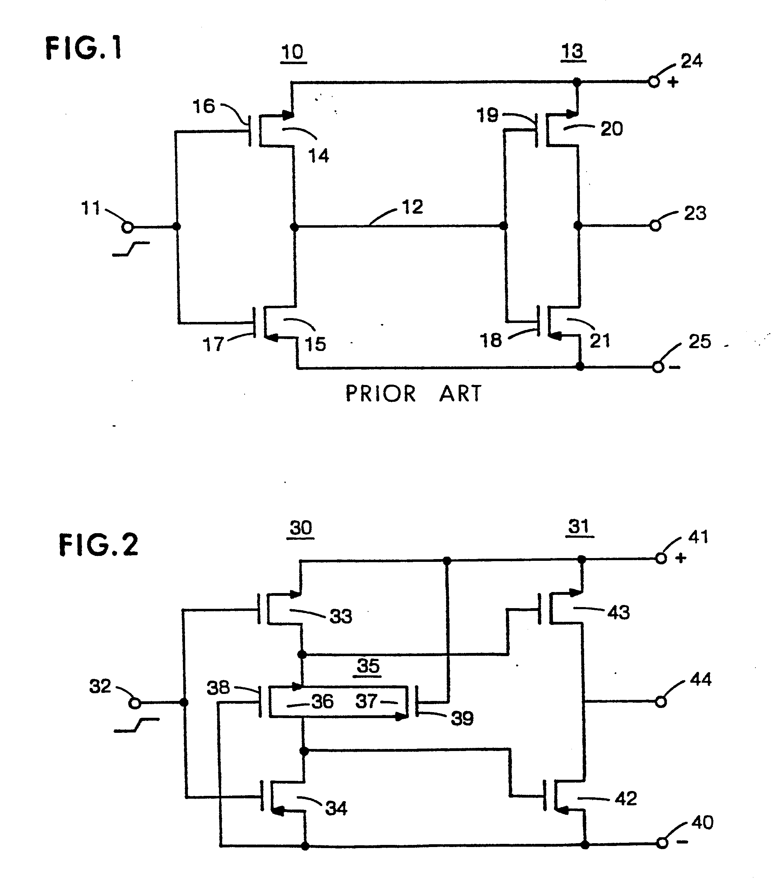

Figure 1, which illustrates prior art CMOS driver circuitry, shows a switching CMOS circuit 10 having an input terminal 11 to which the switching signals are applied. The output 12 from the drain electrodes of the transistors in switching circuit 10 is connected to the input gates of the high current, high speed CMOS driver circuit 13. The switching signal from terminal 11 is applied to the insulated oxide gates 16 and 17 of p- and n-channel

-6-

transistors 14 and 15. The drain electrodes of p-channel transistor 14 and n-channel transistor 15 in switching circuit 10 are connected to gates 18 and 19 of p-channel transistor 20 and n-channel transistor 21 in driver CMOS circuit 13. The drain electrodes of transistors 20 and 21 are connected to a driver output terminal 23. The source electrodes of the p-channel and n-channel transistors in each of the CMOS circuits are connected, respectively, to a positive terminal power supply 24 and the negative terminal of a power supply 25.

In such a prior art CMOS driver circuit a negative input signal to terminal 11 causes p-channel transistor 14 to conduct so that the voltage at its drain electrode and at output line 12 is positive. This positive voltage is applied to gates 18 and 19 of output driver CMOS 13 and drives the n-channel transistor 21 into conduction and the output voltage at terminal 23 is essentially at the negative supply voltage.

When the input voltage at terminal 11 switches from negative to positive, p-channel transistor 14 is switched off and n-channel transistor 15 is switched on, and the voltage on output line 12 goes negative. Conversely, with the input voltage to gates 18 and 19 going negative, n-channel transistor 21 is turned off and p-channel transistor 20 is turned on.

However, the input signal to terminal 11 does not switch instantaneously from negative to positive. The leading and trailing edges of the switching signal have some sort of slope. The duration of the switching interval is short, in the order of 5-10 nanoseconds. However, because of this interval, the transistors in high power CMOS driver 13 also takes a finite time to switch.

n-Channel transistor 21 continues to conduct until the voltage on its gate electrode drops to some threshold above the negative supply voltage coupled to its source electrode. That is, in a typical 5-volt supply system an n-Channel transistor continues to conduct to some degree until the voltage on its gate electrode is less than about one (1) volt above the negative supply voltage. The p-channel transistor, on the other hand, begins to conduct as soon as the voltage on its gate reaches a threshold below the positive supply. voltage. Thus, transistor 20 begins to conduct as soon as the voltage on its gate 19 drops to four volts, i.e., one (1) volt below the positive supply voltage. During the interval when the voltage on gate electrodes 18 and 19 is between +4 and +1 volts, both transistors conduct. With both transistors conducting, a portion of the current flows from the positive supply terminal 24 through p-channel transistor 20 and n-channel transistor 21 to the negative supply terminal 25 bypassing the output completely and constituting a parasitic current which performs no useful work.

-8-

This "shoot-through" current has undesirable consequences in that it draws additional non-useful current and thus requires an increase in the power supply capacity; it creates undesired heat; and in very large scale integrated (VLSI) circuits such as those having five micron, three micron or one micron spacing the increase in current density can have adverse effects on the connector paths between the semiconductor devices.

Figure 2 illustrates a high speed, high current CMOS driver arrangement in which parasitic or "shoot-through" current is minimized or eliminated by delaying "turn-on" of the formerly non-conducting transistor until the current level in the other transistor drops to a very low level or to zero. In the arrangement of figure 2, an additional CMOS "turn-on delay" network -- in a back-to-back connection -- is provided between the n- and p-transistors of the CMOS switching network. The gate voltages of both transistors in the additional CMOS network continuously bias the transistors to a conductive state. During steady state conditions of the switching CMOS transistors, the transistors in the "turn-on" delay network though biased to be conductive do not conduct current because the voltages at their drain and source electrodes are the same. During the switching interval, a voltage drop is developed across one or the other of the transistors of a polarity such as to delay conduction of the previously nonconducting transistor of the high current output driver CMOS until the current in the previously conducting transistor goes to a low level or to zero thus minimizing the parasitic "shoot-through" current.

Figure 2 shows a CMOS switching stage 30 having its outputs coupled to a CMOS output driver stage 31 for selectively switching the high current output driver stage in response to the input switching signals applied to input terminal 32. Input CMOS switching stage 30 consists of complementary p- and n-channel transistors 33 and 34 having their drain electrodes interconnected by a CMOS "turn-on delay" stage 35. The "turn-on delay" CMOS stage 35 consists of p-channel transistor 36 and a n-channel transistor 37 connected in a back-to-back configuration.

Transistors 36 and 37 are conductively biased by permanently connecting their gate electrodes 38 and 39 to the negative and positive power supply input terminals 40 and 41, respectively. Thus, the gate voltage at p-MOS transistor 36 is always negative and the gate voltage of n-channel transistor 37 always has a positive voltage. However, during steady state conditions of the switching and driver CMOS, the source and drain voltages of transistors 36 and 37 (which are the gate voltages for the Driver CMOS transistors) are essentially equal and the voltage difference across transistors 36-37 is zero. The output voltages of the switching stage transistors are applied respectively to the gate electrodes of n-channel transistor 42 and p-channel transistor 43 in CMOS driver circuit 31. The drain electrodes of transistors 42 and 43 are, respectively, connected to an output terminal 44.

When the input signal to terminal 32 is negative and p-channel transistor 33 is fully conductive, a positive voltage at its drain electrode (approximately equal to that at the positive supply terminal 41) is applied through p-channel transistor 36 to the gate electrodes and drives n-channel transistor 42 into conduction. Similarly, when the input voltage is positive and n-channel transistor 34 is in the fully conductive state the negative voltage at the drain electrode of that transistor is coupled to the gate electrodes and drives transistor 43 into conduction through n-channel transistor 37 in "turn-on delay" circuit 35. Thus, once steady state conditions are reached; the voltages on the gates of driver CMOS transistors 42 and 43 are essentially the same as the voltage at the drain electrode of the conducting switching transistor and current flow through the transistors in "turn-on delay" circuit 35 ceases -- that is, when the capacitors formed by the gate electrodes, metal oxide insulator and substrate of the CMOS driver transistors are fully charged to the drain voltage of the CMOS switching stage, no more current flows and transistors 36 and 37 in the "turn-on delay" CMOS become "transparent" (i.e., they have no effect).

During the transition period when the switching voltage at input terminal 32 changes, for example, from negative to positive, p-channel transistor 33 begins to turn off and n-channel transistor 34 begins to turn on. A voltage difference is developed across transistors 36 and 37 and current flows through n-channel transistor 37. Current flows from the gate electrode of transistor 42 through n-channel transistor 34 and the voltage begins dropping towards the voltage at the negative supply terminal 40. The voltage at the gate electrode of p-channel transistor 43 is always more positive than that at the gate of n-channel 42 by virtue of the voltage drop across n-channel transistor 37 which delays "turn-on" of p-channel transistor 43 and prevents it from concucting until n-channel transistor 42 ceases to concuct or conducts at a very low level.

In the same manner, during the transition period when the input switching voltage at input terminal 32 goes from positive to negative (i.e., concucting n-channel transistor 34 begins to turn-off and p-channel transistor 33 begins to turn-on), the voltage developed across "turn-on delay" transistors 36 and 37 increases and the voltages at the gate of n-channel transistor 42 in the driver CMOS 31 is more negative than that at the gate of transistor 43 by virtue of the voltage drop across transistor 36 in the "turn-on" delay" CMOS so the conductive state of the p-channel transistor 43 is reduced to a very low value before 42 turns on. The polarity of the voltage difference between the gate of transistor 43 and the gate of transistor 42 is always the same. The gate of transistor 43 is either equal to or more positive than the gate of transistor 42. This relationship holds in all phases of operation.

In this fashion, it may be seen, that initiation of conduction by the previously nonconducting transistor is delayed until the current from the conducting transistor has been reduced substantially thereby minimizing or eliminating the flow of parasitic current during the interval when both transistors are conducting. This is achieved by minimizing the duration during which both are conducting and also by reducing the magnitude of current flow in the transistor being switched off during this interval.

While the embodiment of the invention illustrated in figure 2 is shown utilizing an active delay network in which a complementary transistor in a CMOS device is connected back-to-back, the invention may also be utilized with only a single such transistor in which event the reduction of the parasitic current is somewhat lower than it will be with both of these transistors connected in the manner shown in figure 2.

0189571

-13-

It will be realized, however, that while a particular embodiment of this invention has been shown, the invention is by no means limited thereto, since many modifications both in the structural arrangement, and the instrumentalities employed may be made. It is contemplated by the appended claims to cover any such modifications as fall within the true spirit and scope of this invention.

-14-

## Claims

What is claimed as new and desired to be secured by U.S. Letters Patent is:

1. In a CMOS driver circuit comprising:

a) a CMOS switching circuit having an input terminal for receiving switching signals, said input terminal being coupled to the gate electrodes of both transistors in said switching circuit;

b) a CMOS driver circuit;

c) means coupling the drain electrodes of the transistors in the CMOS switching circuit to the gate electrodes of the transistors in CMOS driver circuit for switching conduction of the driver CMOS transistors in response to the switching signals;

0189571

-15-

1. (Continued)

d) means for delaying turn-on of the
non-conducting transistor in the
driver CMOS during switching until
the complementary driver transistor
conductivity is reduced including:

1) means coupled between the
complementary switching
transistors for developing a
voltage during the switching
interval of a polarity to delay
turn-on of the previously
conducting driver CMOS
transistor, and

2) means coupling the delay voltage
to the gate electrodes of the
driver CMOS transistors.

2.    The CMOS driver circuit according to claim 1 wherein said means for developing said voltage includes at least one MOS transistor having its source/drain paths coupled between the drain electrodes of the switching CMOS transistors, the gate electrode of said MOS transistor connected to a voltage source of a polarity to bias it for current conduction whereby a voltage drop is developed across the MOS transistor during switching but not during steady state conditions.

3.    The CMOS driver circuit according to claim 2 wherein said means for developing a voltage includes p-MOS and n-MOS transistors having their respective drain and source electrodes interconnected.

4.    The CMOS driver circuit according to claim 3 wherein the junction of the drain electrode of the p-MOS and the source electrode of n-MOS is coupled to the gate of the n-MOS in the driver CMOS and the junction of the source electrode of the p-MOS and drain electrode of the n-MOS is coupled to the gate electrode of the p-MOS of the driver CMOS.

0189571

1/1

## FIG.1

PRIOR ART

## FIG.2

**European Patent Office**

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | PATENT ABSTRACTS OF JAPAN, vol. 5, no. 171 (E-80)[843], 30th October 1981; & JP - A - 56 100 514 (NIPPON DENKI K.K.) 12-08-1981 | 1 | H 03 K 19/094<br>H 03 K 5/02 |
| | --- | | |
| X | PATENT ABSTRACTS OF JAPAN, vol. 8, no. 39 (E-228)[1476], 21st February 1984; & JP - A - 58 196 727 (NIPPON DENKI K.K.) 16-11-1983 | 1 | |
| | --- | | |
| X | PATENT ABSTRACTS OF JAPAN, vol. 8, no. 58 (P-261)[1495], 16th March 1984; & JP - A - 58 207 123 (TOKYO SHIBAURA DENKI K.K.) 02-12-1983 | 1 | |
| | | | **TECHNICAL FIELDS SEARCHED (Int. Cl.4)** |
| A | idem | 2-4 | |
| | --- | | H 03 K 5/02<br>H 03 K 17/16<br>H 03 K 19/094 |
| X | PATENT ABSTRACTS OF JAPAN, vol. 5, no. 11 (E-42)[683], 23rd January 1981; & JP - A - 55 141 828 (HITACHI SEISAKUSHO K.K.) 06-11-1980 | 1 | |
| A | idem | 2-4 | |
| | --- | | |
| A | DE-C-2 737 506 (SIEMENS AG)<br>* figure 1; column 2, lines 14-20 * | 1 | |
| | ---     -/- | | |

The present search report has been drawn up for all claims

| Place of search | Date of completion of the search | Examiner |
|---|---|---|
| BERLIN | 07-03-1986 | ARENDT M |

EPO Form 1503 03 82

**European Patent Office**

## EUROPEAN SEARCH REPORT

### DOCUMENTS CONSIDERED TO BE RELEVANT

Page  2

| Category | Citation of document with indication, where appropriate, of relevant passages | Relevant to claim | CLASSIFICATION OF THE APPLICATION (Int. Cl.4) |
|---|---|---|---|
| A | PATENT ABSTRACTS OF JAPAN, vol. 8, no. 107 (E-245)[1544], 19th May 1984; & JP - A - 53 22443 (FUJI DENKI SOUGOU KENKYUSHO K.K.) 04-02-1984 | 1 | |
| A | IEEE JOURNAL OF SOLID-STATE CIRCUITS, SC-19, no. 4, August 1984, pages 468-473, New-York, US; H.J.M. VEENDRICK "Short-circuit dissipation of static CMOS circuitry and its impact on the design of buffer circuits" | | |

TECHNICAL FIELDS SEARCHED (Int. Cl.4)

The present search report has been drawn up for all claims

| Place of search | Date of completion of the search | Examiner |
|---|---|---|
| BERLIN | 07-03-1986 | ARENDT M |

EPO Form 1503 03 82